# EUROPEAN PATENT APPLICATION

(11) **EP 4 648 100 A1**
(43) Date of publication of application: **12.11.2025**
(21) Application number: 25162786.5
(22) Date of filing: 11.03.2025
(51) Int. Cl.: H01L 23/38, H01L 23/433, H01L 23/44, H01L 23/46, H05K 1/02, H01L 23/34, H01L 23/367, H05K 1/18, H01L 23/427

(54) **THERMOELECTRIC COOLING HYBRID MODULE**

(30) Priority: 07.05.2024 US 202418657051
(71) Applicant: L3Harris Technologies, Inc., Melbourne, FL 32919 (US)
(72) Inventor: PERRY, Spencer, Melbourne, 32919 (US)
(74) Representative: Schmidt, Steffen J.

(57) **Abstract**

A cooling device. The cooling device includes a primary heat path configured to draw heat away from a heat source. The cooling device further includes a secondary heat path, that functions selectively. The secondary heat path is parallel to the primary heat path. The secondary heat path includes an active cooling device configured to remove heat from a surface. The secondary heat path further includes one or more passive elements coupled to the active cooling device that are configured to draw heat from the active cooling device. The primary heat path and secondary heat path are configurable to draw heat from the same heat source.

## Description

### BACKGROUND

### Background and Relevant Art

Electronic systems are ubiquitous. Electronic systems have affected nearly every aspect of modern living. Electronic systems are generally involved in work, recreation, healthcare, transportation, entertainment, household management, etc.

The trajectory of advancement in electronic systems is along the path of reducing system size while increasing system functionality. This is typically accomplished by increasing component density within the systems. This can be accomplished by reducing individual component size and/or reducing space between individual components. However, reduction in component functionality is avoided.

To operate electronic components in electronic systems, a certain amount of energy is required. Thus, as component density increases, so too does electronic power density within the electronic systems. One byproduct of power being supplied to electronic components is heat being dissipated from the electronic components. As electronic component density increases, and electronic power density increases, so too increases the amount of heat to be removed from the system to ensure components continue to operate reliably. For example, a component's operating temperature may determine the efficiency at which the component operates. For example, the higher the temperature at which a component operates, the lower efficiency of operation. This can be due to various factors such as increase in resistances in the component, narrower signal bandwidth that is able to be handled by the component, etc. Further, heat will adversely affect the lifespan of components in an electronic system. That is, the higher the temperature at which components operate, the shorter lifespan of the components.

Further, electronic systems are being deployed in more extreme environments than environments in which they were previously deployed. For example, electronic systems may be deployed in environments where ambient temperatures are high as compared to previous electronic system deployments. Operating in high temperatures only compounds heat issues.

Traditionally, cooling of electronic systems has been accomplished using passive mechanical cooling devices such as heatsinks. However, as component density and power density have increased, other types of cooling have been used, referred to herein as active cooling. Active cooling is performed using devices which are powered to perform heat removal. For example, if excessive heat is being generated by an electronic system, heatsink devices can be augmented with forced air cooling such as fans that force higher quantities of air across the heatsink so as to dissipate more heat from the electronic system. Other types of active cooling include thermoelectric coolers or other heat pumps which actively pump heat from one location to another.

However, the addition of active cooling means that additional power is needed for the electronic system to run the active cooling. This means that additional power will be used by the electronic system, but where the additional power is not directly provided to components in the electronic system which provide the intended functionality of the electronic system. For example, if the electronic system is intended to perform computing functionality, the addition of active cooling means that power is provided to cooling components instead of computation components.

The subject matter claimed herein is not limited to embodiments that solve any disadvantages or that operate only in environments such as those described above. Rather, this background is only provided to illustrate one exemplary technology area where some embodiments described herein may be practiced.

### BRIEF SUMMARY

One embodiment illustrated herein includes a cooling system. The cooling system includes a primary heat path configured to draw heat away from an electronic system. The cooling system further includes a secondary heat path, that functions selectively. The secondary heat path is parallel to the primary heat path. The secondary heat path includes an active cooling device configured to remove heat from a surface. The secondary heat path further includes one or more passive elements coupled to the active cooling device that are configured to draw heat from the active cooling device. The primary heat path and secondary heat path are configurable to draw heat from the same electronic system.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

Additional features and advantages will be set forth in the description which follows, and in part will be obvious from the description, or may be learned by the practice of the teachings herein. Features and advantages of the invention may be realized and obtained by means of the instruments and combinations particularly pointed out in the appended claims. Features of the present invention will become more fully apparent from the following description and appended claims, or may be learned by the practice of the invention as set forth hereinafter.

### BRIEF DESCRIPTION OF THE DRAWINGS

In order to describe the manner in which the above-recited and other advantages and features can be obtained, a more particular description of the subject matter briefly described above will be rendered by reference to specific embodiments which are illustrated in the appended drawings. Understanding that these drawings depict only typical embodiments and are not therefore to be considered to be limiting in scope, embodiments will be described and explained with additional specificity and detail through the use of the accompanying drawings in which:
Figure 1 illustrates a first example of a cooling system;
Figure 2 illustrates a corresponding thermal resistance diagram;
Figure 3 illustrates a second example of a cooling system; and
Figure 4 illustrates a corresponding thermal resistance diagram.

### DETAILED DESCRIPTION

Embodiments illustrated herein provide on-demand augmented active cooling. In particular, embodiments provide at least two parallel heat paths, including a primary heat path and a secondary on-demand heat path. By implementing parallel heat paths, where one of the heat paths is on demand, the on-demand heat path will have minimal impact to thermal performance of the primary heat path.

When parallel heat paths are implemented, each of the heat paths operate independently to draw heat from a heat source, where a heat source may be an electronic device or a heating element (which could be nuclear thermal, solar, thermal capacitor, or other heat source). In contrast, a heat path having serial cooling components operates such that the serial components operate in concert to draw heat from a heat source. For example, a heatsink having a fan is an example of a serial heat path whereby the efficiency of the heatsink is increased when the fan is operating. However, when the fan is not operating, the serial path including the heatsink and the non-operating fan may actually be less effective than a heatsink alone inasmuch as the fan, when not running, tends to impede heat dissipation.

In contrast, when parallel heat paths are implemented, each of the paths functions independently with respect to drawing away and dissipating heat from a heat source, and the secondary heat path not actively operating will not significantly affect operation of the primary heat path.

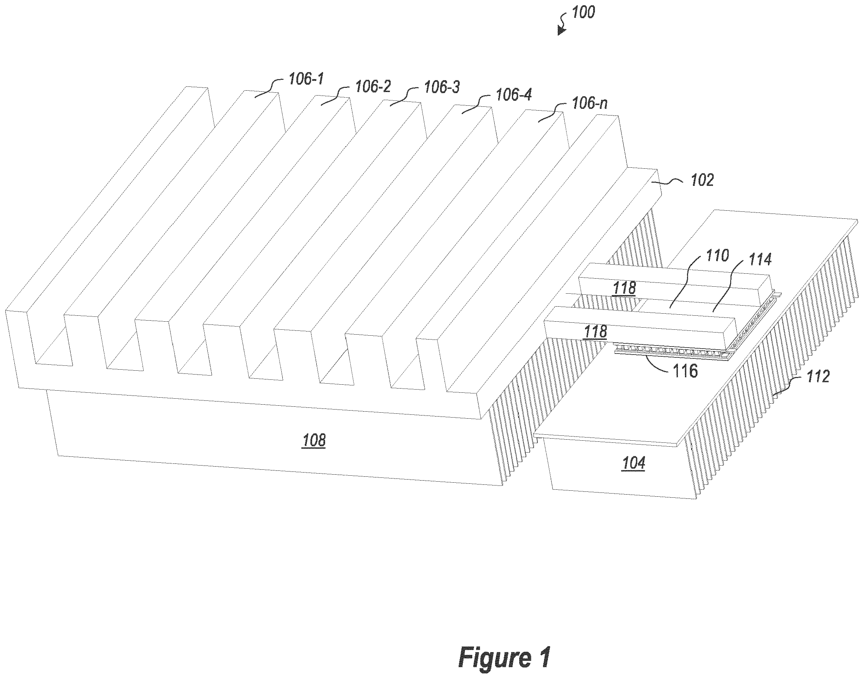

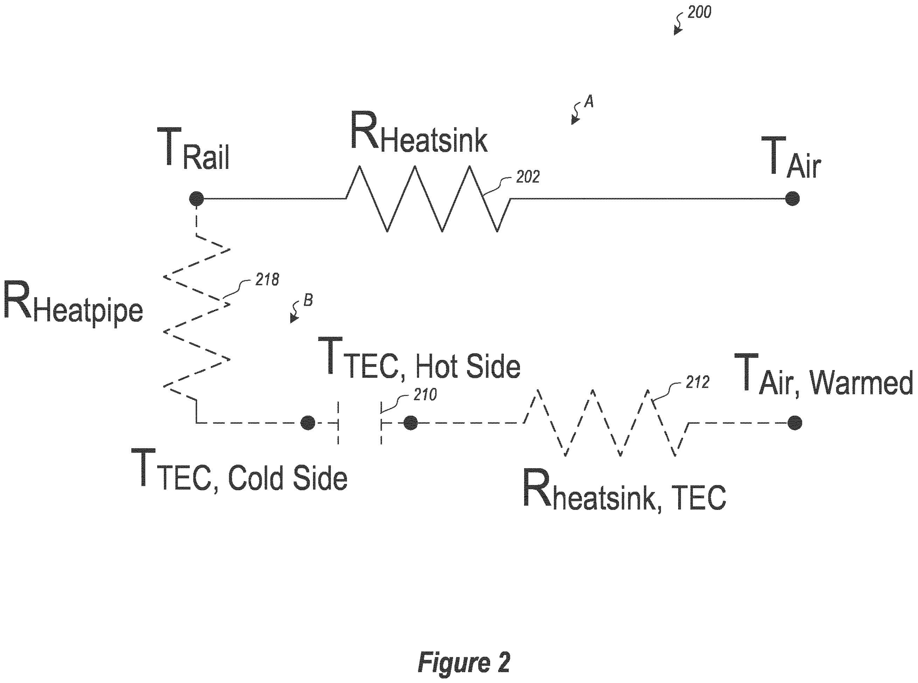

Referring now to Figure 1 a cooling system 100 is illustrated. The cooling system 100 includes a primary heat path A and a secondary heat path B (see Figure 2). As will be illustrated in more detail below, the primary heat path A is in parallel with the secondary heat path B. The primary heat path includes heat flow through the heatsink 102, while the secondary heath path includes heat flow through the heat pipes 118, the thermoelectric cooler 110, the heatsink 112. Further, in this example, the secondary heat path B is an on-demand heat path that can be used for cooling electronic components when additional cooling is desired. In contrast, the primary heat path A will perform constant cooling functionality for electronic components.

In the example illustrated in Figure 1, the primary heat path A comprises a heatsink 102 having fins 108 through which airflow functions to cool electronic components. For example, Figure 1 illustrates a number of slots illustrated as slot 106-1, slot 106-2, slot 106-3, slot 106-4, and slot 106-n. The inclusion of slot 106-n indicates that any appropriate number of slots may be included in the cooling system 100. Electronic components (not shown) can be installed in the slots 106-1 through 106-n. For example, in some embodiments, peripheral cards can be installed in the slots 106-1 through 106-n. The components installed in the slots will generate heat as they operate performing the functionality for which they were intended. For example, a computing electronic component installed in one of the slots will produce heat as it performs computing functionality. In an alternative example, a networking electronic component will produce heat as it performs networking and communication functionality.

As discussed previously, the primary heat path A includes heatsink 102 thermally coupled to the slots 106-1 through 106-n. The heatsink 102 draws heat away from the components installed in the slots 106-1 through 106-n. Air moving through the heatsink 102 moves the heat away from the cooling system 100. So long as the primary heat path A is drawing a sufficient amount of heat away from the components installed in the slots 106-1 through 106-n, the primary heat path A can operate alone to perform the cooling functionality desired for the electronic system. However, if the electronic system is being used in a fashion that generates sufficient heat to cause the electronic system to exceed a predetermined temperature or other condition, then embodiments may engage the secondary heat path B to remove additional heat. For example, if the electronic system is under heavy use resulting in additional power consumption than was previously being used, or the ambient environment in which the electronic system is being operated in becomes hotter than during previous operation, the secondary heat path B may be engaged to remove additional heat from the electronic system.

In the example illustrated in Figure 1, the secondary heat path B comprises an active cooling device, which in this example, is a thermoelectric cooler 110 and a heatsink 112 having fins 104. In particular, power can be applied to the thermoelectric cooler 110. The thermoelectric cooler 110 has a cold side 114 and a hot side 116. When power is applied to the thermoelectric cooler 110, heat is transferred from the cold side 114 to the hot side 116. In some embodiments this can be accomplished by using the Peltier effect. Indeed, in some embodiments, the cold side 114 can be maintained at a temperature that is lower than the ambient temperature in which the cooling system 100 (and the electronic system to which it is attached) is deployed.

Figure 1 further illustrates heat pipes 118. The heat pipes 118 are thermally coupled to the slots 106-1 through 106-n. In this way, heat can be transferred from the slots 106-1 through 106-n to the secondary heat path B. In particular, the heat pipes 118 are thermally coupled to the cold side 114 of the thermoelectric cooler 110. When the thermoelectric cooler 110 is activated, heat will be drawn away from the heat pipes 118 to the hot side 116 of the thermoelectric cooler 110. The heatsink 112 can then dissipate heat from the hot side 116 of the thermoelectric cooler 110.

Referring now to Figure 2, a thermal resistivity diagram 200 corresponding to the cooling system 100 is illustrated. The thermal resistivity diagram 200 illustrates representations of thermal resistances of various components in the cooling system 100. In the thermal resistivity diagram 200, the primary heat path A is shown as solid lines whereas the secondary heat path B is shown in broken lines.

Figure 2 illustrates a heatsink thermal resistance 202 representing the thermal resistance of the heatsink 102. Figure 2 illustrates a heat pipe thermal resistance 218 representing the thermal resistance of the heat pipe(s) 118. Figure 2 illustrates a thermoelectric cooler heat transfer element 210 representing the heat transfer capabilities of the thermoelectric cooler 110. Figure 2 illustrates a thermal resistance 212 representing the thermal resistance of the heatsink 112 coupled to the thermoelectric cooler.

As discussed previously, and as illustrated by the broken lines, the secondary heat path B can be selectively added in parallel to the primary heat path A. In this way, additional cooling can be provided for the electronic system on a selective basis. Note that Figure 2 illustrates the concept that engaging the secondary heat path B does not significantly affect the cooling capabilities of the primary heat path A. That is, the thermoelectric cooler 110 provides a parallel thermal heat path when the thermoelectric cooler 110 is actively powered but does not negatively impact the thermal performance of the electronic system when it is in an unpowered state.

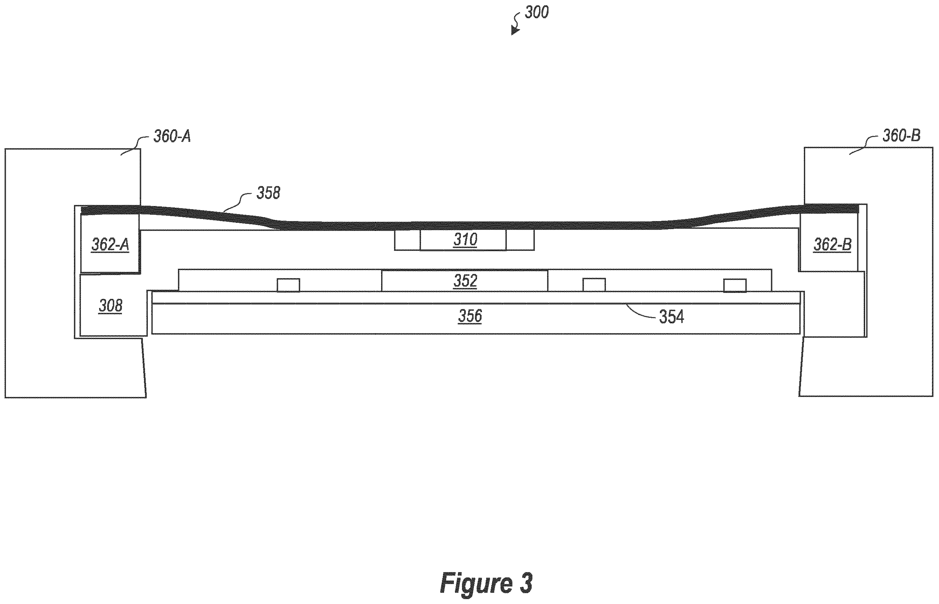

Referring now to Figure 3 an alternative embodiment is illustrated. Figure 3 illustrates a system 300 which includes primary and secondary heat paths.

The system 300 illustrated in Figure 3 includes a heat source, which in this example, is a high-power integrated circuit 352. The high-power integrated circuit 352 performs predetermined electronic functionality, and as a result generates heat. In the example illustrated, the high-power integrated circuit is mounted on a circuit board 354, and the circuit board 354 is covered by a cover 356. To dissipate heat away from the high-power integrated circuit 352, the electronic system 300 includes a heat frame 308, which is a heatsink, thermally coupled to the high-power integrated circuit 352. The heat frame 308 is included in the primary heat path.

The system 300 further includes a secondary heat path which can be selectively engaged to draw additional heat away from the high-power integrated circuit 352. For example, the secondary heat path may be selectively engaged when the high-power integrated circuit 352 is performing significant processing and/or generating significant amounts of heat. Alternatively, or additionally, if the electronic system 300 is deployed in an ambient environment having a temperature that is high enough to affect the operation of the high-power integrated circuit 352 as determined by evaluation of a particular predetermined condition, then the secondary path can be engaged.

In this example, the secondary path includes a thermoelectric cooler 310 thermally coupled to the heat frame 308 at a location on the heat frame 308 that is proximate the high-power integrated circuit 352. Note that placement of the thermoelectric cooler 310 at a location on the heat frame 308 that is proximate the high-power integrated circuit 352 provides more effective cooling benefits than if the thermoelectric cooler 310 were located in a different location. That being said, some embodiments may be implemented where the thermoelectric cooler 310 is located in various other locations.

Figure 3 illustrates various other elements that will contribute to thermal resistance in the primary and secondary heat paths. For example, Figure 3 illustrates a conductive shim 358 that is thermally coupled to the thermoelectric cooler 310 and to rails 360-A and 360-B. In some embodiments the conductive shim 358 is coupled to the thermoelectric cooler 310 and the heat frame 308 using attachment mechanisms such as thermal epoxy, screws, springs, or other attachment mechanisms. The conductive shim 358 may take one or more of a number of different forms. For example, the conductive shim 358 may be formed from copper strips, heat pipes, or other conductive elements.

In the example illustrated in Figure 3, the conductive shim 358 is also coupled to the rails 360-A and 360-B. In the example illustrated in Figure 3, printed circuit board retainers 362-A and 362-B respectively are used to press the conductive shim 358 against the rails 360-A and 360-B. The rails 360-A and 360-B can also be part of the heat paths and can dissipate heat.

Note that in some embodiments, due to the heat pumping characteristics of the thermoelectric cooler 310, sub-ambient cooling can be provided for the high-power integrated circuit 352.

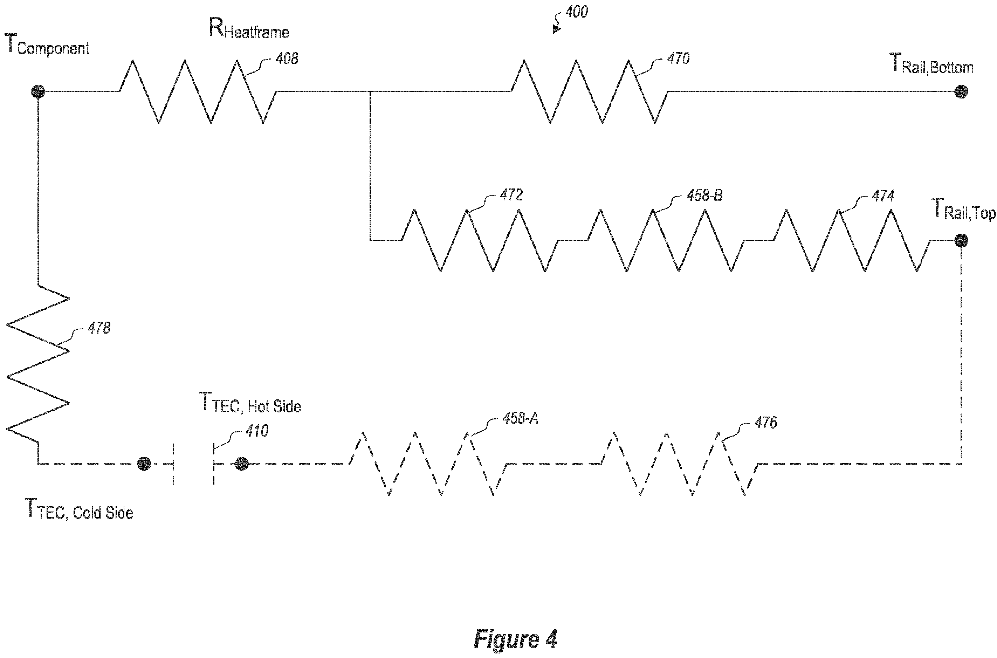

Referring now to Figure 4, a thermal resistivity diagram 400 corresponding to the cooling system 300 is illustrated. The thermal resistivity diagram 400 illustrates representations of thermal resistances of various components in the cooling system 300. In the thermal resistivity diagram 400, the primary heat path is shown as solid lines whereas the secondary heat path is shown in broken lines.

Figure 4 illustrates a primary heat path which includes a thermal resistance 408 which represents the thermal resistance of the heat frame 308. The primary heat path further includes a thermal resistance 470. The thermal resistance 470 represents the thermal resistance between the heat frame 308 and the rails 360-A and 360-B. Note that this thermal resistance is affected by the quality of contact between the heat frame 308 and the rails 360-B and 360-A. This resistance, as with other contact resistances illustrated herein, may be affected by shapes, textures, presence of thermal pastes, etc. In general, less interstitial space between two components results in lower thermal resistances between the components.

The primary heat path includes a supplemental heat path formed due to passive cooling effects of various elements in the secondary heat path. In particular, the supplemental heat path includes thermal resistances 472 representing the thermal resistance of the printed circuit board retainers 362-A and 362-B, the thermal resistance 458-B representing the thermal resistance of the shim 358, and the thermal resistance 474 representing the thermal resistance of the contact between the shim 358 and the rails 360-A and 360-B.

The secondary heat path is represented by a thermoelectric cooler heat transfer element 410 representing the heat transfer capabilities of the thermoelectric cooler 310, the thermal resistance 458-A representing the thermal resistance of the shim 358 and the thermal resistance 476 representing the thermal resistance between the shim 358 and the rails 360-A and 360-B.

Note that a thermal resistance 478 is also illustrated representing the contact type thermal resistance of the conductive shim 358 to the heat frame 308.

In some embodiments, targeting augmented cooling to specific location(s) as needed is achieved by integrating heat pipes into embodiments. The combination of heat pipes and active cooling allows for remote heat transfer meanwhile providing direct cooling to targeted electronics.

Embodiments may be implemented where the thermoelectric cooler is isolated from the primary heatsink in the primary heat path. This prevents waste heat of the thermoelectric cooler from affecting neighboring electronics. In some embodiments, the primary heat path is heat transfer isolated from the secondary, selectable, heat path by at least an order of magnitude as compared to heat transfer in the heat paths. For example, if the primary and secondary heat paths have a heat flow of 100 W, a heat path between the two will be no more than 10 W.

However, in some embodiments, it may be desirable to selectively mechanically couple the heat paths to allow for more heat flow between the heat paths. In some embodiments, that can be done using bi-metal strips, mechanical actuators that move passive heating elements to be in contact with each other, or other appropriate selective tools.

In the illustrated embodiments, selective cooling has been illustrated. The cooling can be on-demand and targeted. For example, if cooling requirements are met with only the primary cooling paths 99% of the operational time of a system, then targeted cooling of the secondary paths only need to be applied 1% of the operational time. Note that in some embodiments, a thermoelectric cooler, when off works as a thermal insulator, so heat is not conducted to the conductive shim, which would result in overheating of electronic components.

The present invention may be embodied in other specific forms without departing from its characteristics. The described embodiments are to be considered in all respects only as illustrative and not restrictive. The scope of the invention is, therefore, indicated by the appended claims rather than by the foregoing description. All changes which come within the meaning and range of equivalency of the claims are to be embraced within their scope.

## Claims

1. A cooling system comprising:
a primary heat path configured to draw heat away from a heat source;
a secondary heat path, that functions selectively, the secondary heat path being parallel to the primary heat path, the secondary heat path comprising:
an active cooling device configured to remove heat from a surface of the heat source; and
a passive element thermally coupled to the active cooling device, and configured to draw heat from the active cooling device; and
wherein the primary heat path and secondary heat path are configurable to draw heat from the same heat source.

2. The cooling system of claim 1 further wherein the primary heat path and the one or more passive elements are thermally isolated from each other by at least one order of magnitude as compared to heat through the paths.

3. The cooling system of claim 1, wherein the primary heat path and the one or more passive elements are selectively mechanically couplable to allow heat to flow between the primary heat path and the secondary heat path.

4. The cooling system of claim 1, wherein the one or more passive elements comprise a shim thermally bonded to the active cooling device and thermally bonded to a heatsink in the primary heat path.

5. The cooling system of claim 1, wherein the one or more passive elements comprise a shim thermally bonded to the active cooling device.

6. The cooling system of claim 1, wherein the heat source comprises a semiconductor integrated circuit.

7. The cooling system of claim 1, wherein the primary heat path is passive.

8. A method of cooling a device, the method comprising:
drawing heat away from a heat source through a primary heat path;
selectively engaging a secondary heat path, the secondary heat path being parallel to the primary heat path, the secondary heat path being engaged by selectively activating an active cooling device configured to remove heat from the same heat source.

9. The method of claim 8, wherein the primary heat path and the secondary heat path are thermally isolated from each other by at least one order of magnitude as compared to heat through the paths.

10. The method of claim 8, further comprising selectively mechanically coupling the primary heat path and one or more passive elements of the secondary heat path to allow heat to flow between the primary heat path and the secondary heat path.
